# FASCICULE DE BREVET EUROPEEN

(11) **EP 0 365 904 B1**
(45) Date de publication et mention de la délivrance du brevet: **03.11.1993**
(21) Numéro de dépôt: 89118705.6
(22) Date de dépôt: 09.10.1989
(51) Int. Cl.: H04M 1/64, H04M 1/02, G11B 33/02, H05K 5/02

(54) **Dispositif de verrouillage de sécurité**
Sicherheits-Verriegelungsvorrichtung
Safety locking device

(30) Priorité: 13.10.1988 FR 8813478
(43) Date de publication de la demande: 02.05.1990
(73) Titulaire: ALCATEL BUSINESS SYSTEMS, F-75008 Paris (FR)
(72) Inventeur: Dortu, Giovanni, F-95240 Cormeilles en Parisis (FR); Buhagiar, François, F-93700 Drancy (FR)
(74) Mandataire: Weinmiller, Jürgen

(56) Documents cités:
- EP-A- 0 176 676
- EP-A- 0 237 117
- DE-B- 1 096 974
- DE-U- 7 529 370
- GB-A- 1 260 288

## Description

La présente invention concerne la sécurité électrique des appareillages téléphoniques.

Les normes de sécurité imposent qu'aucune partie d'un appareillage téléphonique accessible à la main, sans l'utilisation d'outil, ne soit susceptible d'être portée à un potentiel électrique dangereux pour l'usager. Dans les postes téléphoniques simples, cette condition est respectée en enfermant les parties métalliques réputées dangereuses dans des boîtiers isolants qui ne peuvent être ouverts sans outil, grâce à l'utilisation de vis ou tétons de blocage nécessitant un tournevis pour leur déblocage. Pour certains appareillages téléphoniques ayant des boîtiers avec des trappes, par exemple de logement de pile ou de cassette de bande magnétique dans le cas de répondeur téléphonique, on utilise des couvercles de trappe bloqués par des verrous sans tête de préhension manoeuvrables uniquement à l'aide de tournevis ou d'une pointe d'outil. Cela est cependant malcommode pour un usager qui n'a pas toujours un outil à portée de la main lorsqu'il doit changer une pile ou une cassette de bande magnetique.

La présente invention a pour but d'assurer la sécurité électrique d'un appareillage téléphonique ayant un boîtier avec trappe pour le logement d'un composant amovible tout en préservant la commodité de manipulation, cela en obligeant l'usager à déconnecter l'appareillage téléphonique avant et pendant l'ouverture de la trappe.

Elle a pour objet un dispositif de verrouillage de sécurité pour un couvercle de trappe d'un socle d'appareillage téléphonique raccordé à une ligne téléphonique par un connecteur à deux parties embrochables constituées d'une embase fixée dans le socle et d'une fiche fixée à l'extrémité d'un cordon de raccordement. Ce dispositif de verrouillage comporte des moyens de contrôle d'accès pour empêcher l'accès de la fiche à l'embase lorsque le couvercle est ouvert, pour obliger à déconnecter le cordon de raccordement du socle avant de pouvoir ouvrir le couvercle de la trappe, et pour n'autoriser l'accès de la fiche à l'embase et ne permettre son embrochage pour le raccordement du cordon que lorsque le couvercle de la trappe est fermé.

Avantageusement, les moyens de contrôle d'accès sont constitués d'un volet qui coulisse dans le socle de l'appareillage téléphonique devant l'embase du connecteur entre une position de fermeture au cours de laquelle il dégage l'accès de l'embase à la fiche du connecteur et maintient le couvercle de la trappe fermé, et une position d'ouverture au cours de laquelle il obstrue l'accès de l'embase à la fiche du connecteur et autorise l'ouverture du couvercle de la trappe. Ce volet peut être constitué d'une pièce distincte du couvercle de trappe ou faire partie de celui-ci.

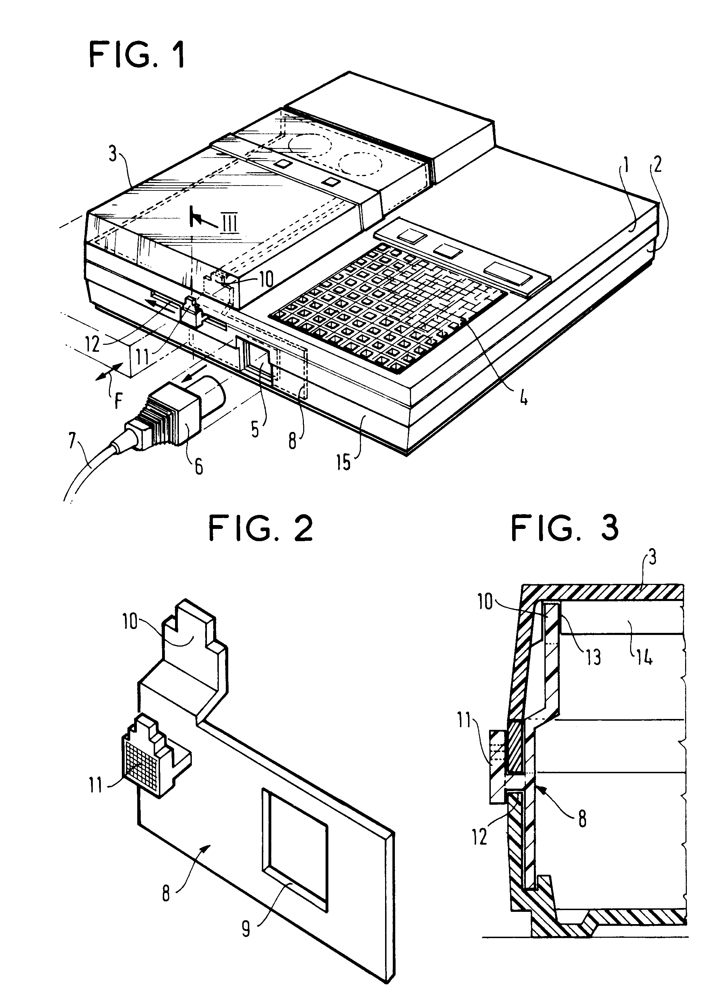

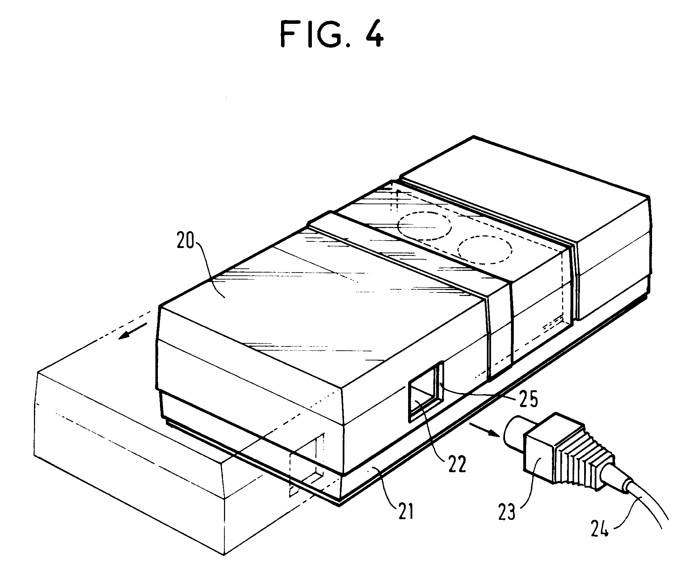

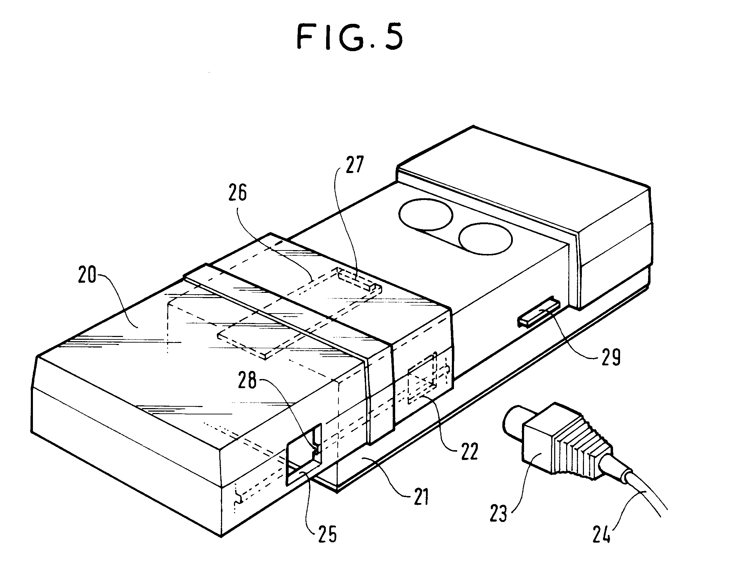

D'autres caractéristiques et avantages de l'invention ressortiront de la description ci-après de deux modes de réalisation donnés à titre d'exemple. Cette description sera faite en regard du dessin dans lequel :
- une figure 1 montre une vue en perspective d'un socle de répondeur téléphonique avec un couvercle de trappe de logement de cassette de bande magnétique coulissant et un connecteur de raccordement de ligne téléphonique débrochable dans l'axe de coulissement du couvercle,
- une figure 2 montre une vue en perspective d'un volet d'obturation utilisé dans le socle de répondeur téléphonique représenté à la figure 1 pour condamner l'accès à l'embase du connecteur de raccordement de ligne pendant l'ouverture du couvercle de trappe de logement de cassette de bande magnétique,
- une figure 3 est une vue en coupe verticale partielle selon la ligne III de la figure 1 et
- des figures 4 et 5 montrent en perspective un autre socle de répondeur téléphonique ayant un couvercle de trappe de logement de cassette de bande magnétique coulissant et un connecteur de raccordement de ligne téléphonique débrochable dans une direction perpendiculaire de l'axe de coulissement du couvercle, l'une des figures correspondant à une position fermée et l'autre à une position ouverte.

Le socle de répondeur téléphonique représenté à la figure 1 a une forme rectangulaire plate. Formé de deux demi-coquilles 1, 2 en matière plastique moulée il présente sur le dessus, côté droit, un mécanisme de lecteur enregistreur de cassette de bande magnétique recouvert par un couvercle 3 en surépaisseur et, côté gauche, une grille 4 cache haut-parleur. Une ouverture 5 dans la paroi latérale du socle donne accès à l'embase d'un connecteur débrochable dont la fiche 6 est fixée à l'extrémité d'un cordon 7 de raccordement à une ligne téléphonique.

Le couvercle 3 représenté en position de fermeture coulisse selon l'axe F à la manière d'un tiroir grâce à un système de glissières non représenté. Il est prisonnier du socle et s'arrête en bout de course d'ouverture dans une position de butée dès que la cassette de bande magnétique devient accessible.

Le mouvement d'ouverture du couvercle 3 est contrôlé à l'aide d'un volet 8 visible en transparence à travers la paroi latérale 15 qui est présentée à l'avant du socle sur la figure 1 et qui correspond à la face arrière du répondeur pour l'utilisateur. Ce volet 8 est situé derrière cette paroi latérale 15 du socle au niveau de l'ouverture 5 donnant accès à l'embase du connecteur de ligne téléphonique et coulisse horizontalement entre une position de fermeture et une position d'ouverture. Il est percé d'une fenêtre 9 aux dimensions de l'ouverture 5 et comporte un doigt latéral déporté 10 de blocage du couvercle 3 et une tirette d'actionnement 11 accrochée à son flanc et saillant hors de la paroi latérale 15 du socle au travers d'une fente de glissière horizontale 12.

En position de fermeture, le volet 8 présente sa fenêtre 9 devant l'ouverture 5 et dégage l'accès de l'embase du connecteur à la fiche pour permettre le raccordement du répondeur à une ligne téléphonique tandis que son doigt 10 vient sous le couvercle 3 à l'encontre d'une butée 13 pour maintenir le couvercle 3 fermé.

En position d'ouverture, le volet 8 dégage sa fenêtre 9 de l'ouverture 5 qu'il obstrue pour interdire l'accès de l'embase du connecteur à la fiche 6 et obliger à déconnecter le répondeur de la ligne téléphonique tandis que son doigt 10 s'efface latéralement de la butée 13 et autorise l'ouverture du couvercle 3.

La butée 13 est formée sur la paroi interne du couvercle 3 par l'extrémité d'une nervure 14 qui est disposée parallèlement à la direction de coulissement du couvercle 3 et qui vient frotter latéralement sur le doigt 10 du volet 8 pour empêcher le retour du volet 8 en position de fermeture pendant l'ouverture du couvercle 3 et interdire un raccordement du répondeur à une ligne téléphonique tant que le couvercle 3 n'est pas fermé.

La coupe de la figure 3 qui montre le volet 8 et le couvercle 3 en position de fermeture, illustre plus particulièrement la position du doigt 10 derrière la butée 13 constituée de l'extrémité de la nervure 14 en relief sur la face inférieure du couvercle 3.

La figure 4 illustre un autre mode de réalisation de répondeur téléphonique dans lequel le volet obturant le connecteur de raccordement à une ligne téléphonique fait partie de l'un des flancs du couvercle coulissant recouvrant la trappe du mécanisme de lecteur enregistreur de cassette de bande magnétique.

Ce couvercle coulissant 20 s'étend sur une partie de la surface supérieure du socle 21 d'un bord à l'autre, avec des flancs recouvrant en partie les parois avant et latérales du socle 21 où ce couvercle s'accroche, par exemple par l'intermédiaire de deux rainures latérales 28, réalisées longitudinalement chacune sur un flanc de couvercle de manière à venir coiffer des plots de maintien 29 disposés latéralement de part et d'autre du socle. Comme précédemment, le couvercle 20 coulisse vers l'avant du socle 21, ou vers l'arrière, à la manière d'un tiroir et s'arrête en bout de course d'ouverture dans une position de butée où la cassette de bande magnétique devient accessible. La limitation de course du couvercle par rapport au socle est ici obtenue par une butée 27 en saillie située sur le socle et coulissant dans une rainure longitudinale complémentaire 26 du couvercle, fermée à ses extrémités. Le flanc latéral gauche du couvercle coulissant 20 recouvre entièrement une ouverture 22 du socle 21 donnant accès à l'embase d'un connecteur débrochable dont la fiche 23 est fixée à l'extrémité d'un cordon 24 de raccordement à une ligne téléphonique et présente une fenêtre 25 aux dimensions de l'ouverture 22. En position de fermeture du couvercle 20 cette fenêtre 25 vient encadrer l'ouverture 22 et permet le raccordement du répondeur à une ligne téléphonique. Dès le début d'un mouvement à l'ouverture du couvercle coulissant 20, elle se dégage de l'ouverture 22 du socle 21 qui est progressivement occultée par le flanc latéral gauche du couvercle 20 pour interdire l'accès à l'embase du connecteur. La poursuite du mouvement à l'ouverture du couvercle coulissant 20 impose un retrait de la fiche 23 du connecteur et par conséquent le débranchement de la ligne téléphonique qui ne peut être rebranchée que le couvercle 20 fermé.

## Revendications

1. Dispositif de verrouillage de sécurité pour un couvercle (3) de trappe d'un socle (1, 2) d'un appareillage téléphonique raccordé à une ligne téléphonique par un connecteur à deux parties embrochables constituées d'une embase fixée au socle et d'une fiche (6) fixée à l'extrémité d'un cordon (7) de raccordement caractérisé en ce qu'il comporte des moyens de contrôle d'accès pour empêcher l'accès de la fiche (6) à l'embase lorsque le couvercle est ouvert, pour obliger à déconnecter le cordon (7) de raccordement avant ouverture du couvercle (3) de la trappe, et pour autoriser l'accès de la fiche (6) à l'embase et permettre son embrochage pour le raccordement du cordon (7) lorsque le couvercle (3) de la trappe est fermé.

2. Dispositif selon la revendication 1, caractérisé en ce que lesdits moyens de contrôle d'accès comportent un volet (8) coulissant dans le socle (1, 2) devant l'embase du connecteur, entre une position de fermeture qui coïncide avec la position de fermeture du couvercle (3) de trappe et où il dégage l'accès de la fiche (6) à l'embase du connecteur pour permettre l'embrochage de la fiche (6) du cordon (7) de raccordement, et une position d'ouverture qui coïncide avec l'ouverture du couvercle (3) de trappe et où il obstrue l'accès de la fiche (6) à l'embase du connecteur obligeant à déconnecter du socle (1, 2) le cordon (7) de raccordement.

3. Dispositif selon la revendication 2 pour un couvercle de trappe coulissant, caractérisé en ce que ledit volet (8) est pourvu d'un doigt (10) coopérant, en position de fermeture du volet (8) et du couvercle (3) de la trappe, avec une butée (13) de la paroi interne du couvercle (3) de la trappe pour empêcher l'ouverture du couvercle (3) et, en position d'ouverture du volet (8) avec une nervure (14) en relief sur la paroi interne du couvercle (3) de la trappe prolongeant la butée (13) parallèlement à la direction de coulissement du dit couvercle (3) pour empêcher le retour du volet (8) en position de fermeture tant que le couvercle (3) de la trappe n'est pas fermé.

4. Dispositif selon la revendication 3, caractérisé en ce que ledit volet (8) est pourvu sur l'un de ses flancs d'une tirette d'actionnement (11) dépassant à l'extérieur du socle par la fente (12) d'une glissière parallèle à l'axe de coulissement du volet (8).

5. Dispositif selon la revendication 2, caractérisé en ce que ledit volet (8) fait partie de la paroi du couvercle (20) de la trappe.

## Claims

1. A safety interlock for a cover (3) of a housing in a telephone apparatus case (1, 2), the telephone apparatus being connected to a telephone line via a connector having two pluggable portions constituted by a receptacle fixed to the case and a plug (6) fixed to the end of a connection cord (7), the interlock being characterized in that it comprises access controlling means for preventing the plug (6) gaining access to the receptacle when the cover is open, for requiring the connection cord (7) to be disconnected prior to opening the cover (3), and for allowing the plug (3) to gain access to the receptacle in order to be plugged thereto for providing connection to the cord (7) when the cover (3) is closed.

2. An interlock according to claim 1, characterized in that said access controlling means comprise a flap (8) sliding inside the case (1, 2) in front of the connector receptacle, between a closed position which coincides with the closed position of the cover (3) in which access for the plug (6) to the connector receptacle is left unobstructed in order to enable the plug (6) of the connection cord (7) to be plugged thereto, and an open position which coincides with the cover (3) being open and in which it obstructs access of the plug (6) to the connector receptacle, thereby obliging the connection cord (7) to be disconnected from the case (1, 2).

3. An interlock according to claim 2, for a sliding cover, the interlock being characterized in that said flap (8) is provided with a finger (10) which cooperates, in the closed position of the flap (8) and of the cover (3) with an abutment (13) on the inside wall of the cover (3) in order to prevent the cover (3) from being opened, and in the open position of the flap (8) with a rib (14) projecting from the inside wall of the cover (3) and extending the abutment (13) parallel to the sliding direction of said cover (3) in order to prevent the flap (8) from returning to its closed position so long as the cover (3) is not closed.

4. An interlock according to claim 3, characterized in that said flap (8) is provided on one of its flanks with an actuator knob (11) projecting outside the case via the slot (12) of a slideway running parallel to the sliding access of the flap (8).

5. An interlock according to claim 2, characterized in that said flap (8) constitutes a portion of the wall of the cover (20).

## Patentansprüche

1. Sicherheits-Verriegelungsvorrichtung für einen Fachdeckel (3) eines Gehäuses (1, 2) einer Telefonanlage, die mit einer Telefonleitung über eine Steckverbindung mit zwei Steckteilen verbunden ist, die aus einem im Gehäuse befestigten Steckersockel und einem am Ende einer Verbindungsschnur (7) befestigten Stecker (6) bestehen, dadurch gekennzeichnet, daß sie Zugangs-Steuermittel aufweist, um den Zugang des Steckers (6) zum Steckersockel zu verhindern, wenn der Deckel geöffnet ist, und um zu erzwingen, daß die Verbindungsschnur (7) vor dem Öffnen des Deckels (3) des Fachs herausgezogen wird, und um den Zugang des Steckers (6) zum Steckersockel und sein Einstecken zum Anschluß der Schnur (7) zu erlauben, wenn der Deckel (3) des Fachs geschlossen ist.

2. Vorrichtung nach Anspruch 1, dadurch gekennzeichnet, daß die Zugangs-Steuermittel einen Schieber (8) aufweisen, der im Gehäuse (1, 2) der Telefonanlage vor dem Steckersockel de Steckverbindung zwischen einer Verschlußstellung, die mit der Verschlußstellung des Fachdeckels (3) zusammenfällt und in der er den Zugang des Steckers (6) zum Steckersockel der Steckverbindung freilegt, um das Einstecken des Steckers (6) der Verbindungsschnur (7) zu erlauben, und einer Öffnungsstellung gleitet, die mit der Öffnung des Deckels (3) zusammenfällt und in der er dem Stecker (6) den Zugang zum Steckersockel des Verbinders verwehrt und dazu zwingt, die Verbindungsschnur (7) vom Gehäuse (1, 2) zu lösen.

3. Vorrichtung nach Anspruch 2 für einen gleitenden Fachdeckel, dadurch gekennzeichnet, daß der Schieber (8) mit einem Finger (10) ausgestattet ist, der in der Schließstellung des Schiebers (8) und des Fachdeckels (3) mit einem Anschlag (13) an der Innenwand des Deckels (3) zusammenwirkt, um die Öffnung des Deckels (3) zu verhindern, und in der Öffnungsstellung des Schiebers (8) mit einer vorstehenden Rippe (14) auf der Innenwand des Deckels (3) des Fachs, die den Anschlag (13) parallel zur Gleitrichtung des Deckels (3) verlängert, um die Rückkehr des Schiebers (8) in die Schließstellung zu verhindern, solange der Deckel (3) des Fachs nicht geschlossen ist.

4. Vorrichtung nach Anspruch 3, dadurch gekennzeichnet, daß der Schieber (8) auf einer seiner Flanken mit einem Betätigungsgriff (11) ausgestattet ist, der außen aus dem Gehäuse durch den Schlitz (12) einer Gleitschiene parallel zur Gleitachse des Schiebers (8) vorsteht.

5. Vorrichtung nach Anspruch 2, dadurch gekennzeichnet, daß der Schieber (8) Teil der Wand des Deckels (20) des Fachs ist.
